# EUROPÄISCHE PATENTSCHRIFT

(11) **EP 0 614 122 B1**
(45) Veröffentlichungstag und Bekanntmachung des Hinweises auf die Patenterteilung: **10.04.1996**
(21) Anmeldenummer: 94810110.0
(22) Anmeldetag: 23.02.1994
(51) Int. Cl.: G03F 7/027, G03C 9/08, C08F 20/36

(54) **Tetraacrylate enthaltende polymerisierbare Gemische**
Tetra-acrylates containing polymerizable mixtures
Mélanges polymerisables contenant des tétra-acrylates

(30) Priorität: 05.03.1993 CH 681/93
(43) Veröffentlichungstag der Anmeldung: 07.09.1994
(73) Patentinhaber: CIBA-GEIGY AG, CH-4002 Basel (CH)
(72) Erfinder: Wolf, Jean-Pierre, Dr., CH-1791 Courtaman (CH); Schulthess, Adrian, Dr., CH-1734 Tentlingen (CH); Steinmann, Bettina, Dr., CH-1724 Praroman (CH); Hunziker, Max, Dr., CH-3186 Düdingen (CH)

(56) Entgegenhaltungen:
- EP-A- 0 125 862
- EP-A- 0 425 441
- EP-A- 0 506 616
- DATABASE WPI Section Ch, Week 7913, Derwent Publications Ltd., London, GB; Class A23, AN 79-24569B & JP-A-54 022 498 (ASAHI ELECTROCHEM IND KK) 20. Februar 1979
- DATABASE WPI Section Ch, Week 7913, Derwent Publications Ltd., London, GB; Class A23, AN 79-24569B & JP-A-54 022 498

## Beschreibung

Die vorliegende Erfindung betrifft die Verwendung von bestimmten Tetraacrylaten als Formulierungskomponente für photopolymerisierbare Harzgemische, die in stereolithographische Verfahren eingesetzt werden, neue photoempfindliche Zusammensetzungen auf Basis von Acrylaten und enthaltend die bestimmten Tetraacrylate sowie ein Verfahren zur Herstellung von Formkörpern oder Beschichtungen, insbesondere zur Herstellung von dreidimensionalen Gegenständen nach dem stereolithographischen Verfahren.

Strahlungsempfindliche flüssige Harze oder Harzsysteme, die sich für die Herstellung von dreidimensionalen Gegenständen nach dem im US-Patent 4,575,330 beschriebenen stereolithographischen Verfahren eignen, sind bekannt, doch erweisen sich manche Harze als zu viskos, andere wiederum sind zu wenig lichtempfindlich oder unterliegen beim Härten einem zu grossen Schrumpfungsprozess. Auch lassen die Festigkeitseigenschaften der aus photogehärteten Harzen erhaltenen Formkörper oft zu wünschen übrig.

Aus der EP-A-0 425 441 ist es bekannt, dass man durch Zugabe eines Urethan(meht)acrylates mit einer Funktionalität von 2 bis 4 zu einem photoempfindlichen Gemisch für die Herstellung von dreidimensionalen Gegenständen mittels des stereolithographischen Verfahrens die Schlagzähigkeit und Reissdehnung der so hergestellten Gegenstände erhöhen kann, doch gleichzeitig werden die Grünfestigkeit und der Elastizitätsmodul dieser Gegenstände erniedrigt.

Es wurde nun gefunden, dass Tetraacrylate der unten angegebenen Formel I oder II, die hochviskose Verbindungen darstellen, sich hervorragend als Formulierungskomponente für Harzgemische eignen, die in stereolithographische Verfahren eingesetzt werden, und dass man mit solchen, die Tetraacrylate enthaltenden Harzgemischen gleichzeitig mehrere mechanische Eigenschaften der daraus herstellten Gegenstände, wie Grünfestigkeit, den Elastizitätsmodul, die Reissdehung sowie die Schlagzähigkeit, vorteilhaft beeinflussen kann.

Gegenstand vorliegender Erfindung ist somit die Verwendung von Tetraacrylaten der Formel I oder II 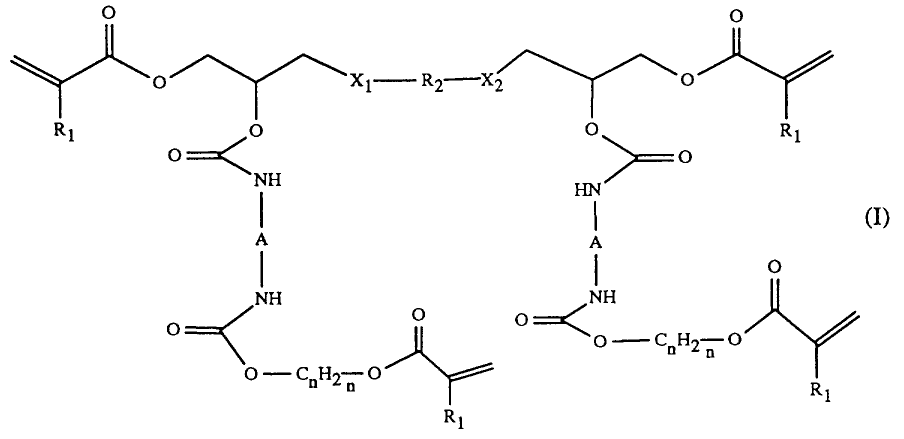 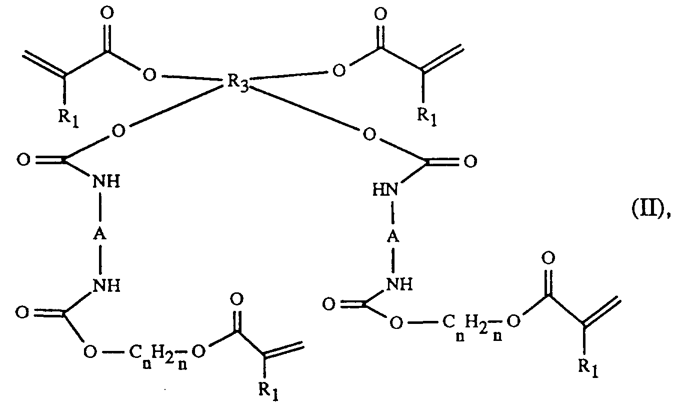 worin
R₁ für ein Wasserstoffatom oder Methyl steht,
X₁ und X₂ unabhängig voneinander je für -O- oder -CO-O- stehen,
R₂ einen zweiwertigen aliphatischen, cycloaliphatischen oder aromatischen Rest einer keine Glycidylether- oder -estergruppen mehr aufweisenden Diglycidylverbindung bedeutet,
A einen zweiwertigen aliphatischen, cycloaliphatischen oder aromatischen Rest einer keine Isocyanatgruppen mehr aufweisenden Diisocyanatverbindung darstellt,
n für eine ganze Zahl von 1 bis 8 steht und
R₃ einen vierwertigen cycloaliphatischen Rest einer keine am cycloaliphatischen Ring mehr gebundenen 1,2-Epoxidgruppe aufweisenen Diepoxidverbindung bedeutet, als Formulierungskomponente für Photopolymerisierbare Harzgemische, die in stereolithographische Verfahren eingesetzt werden.

Vorzugsweise verwendet man als Formulierungskomponente Tetraacrylate der Formel I und II, worin
R₁ für ein Wasserstoffatom oder Methyl steht,
X₁ und X₂ je für -O- oder -CO-O- stehen,
R₂ einen zweiwertigen, linearen oder verzweigten Kohlenwasserstoffrest mit bis zu 20 C-Atomen, einen Rest der Formeln -(Alkylen-O)ₘ-Alkylen-, wobei das Alkylen 1 bis 8 C-Atome enthält und m für null oder eine ganze Zahl von 1 bis 100 steht, ferner 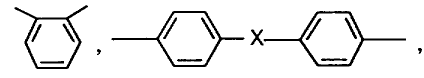 wobei X für ein lineares oder verzweigtes Alkylen mit 1 bis 6 C-Atomen steht, 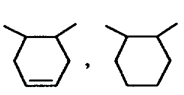 oder 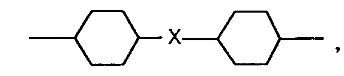 wobei X die zuvorgenannte Bedeutung hat, bedeutet,
A einen zweiwertigen aliphatischen Kohlenwasserstoffrest mit bis zu 6 C-Atomen, einen unsubstituierten oder methylsubstituierten Phenylenrest, einen Rest der Formeln 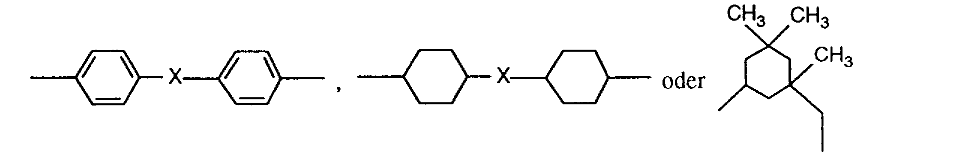 bedeutet, wobei X die zuvorgenannte Bedeutung hat, und
R₃ einen Rest der Formeln 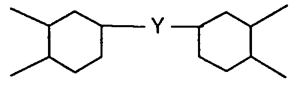 oder 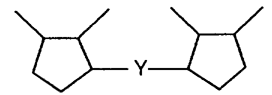 bedeutet, wobei Y für -CO-O-CH₂-, -CO-O-(CH₂)_{P}-O-CO- oder -CH₂-O-CO-(CH₂)_{P}-CO-O-CH₂- steht und p eine ganze Zahl von 2 bis 12 bedeutet.

Gegenstand vorliegender Erfindung sind auch photopolymerisierbare Gemische, enthaltend
(a) ein Tetraacrylat der Formel I oder II 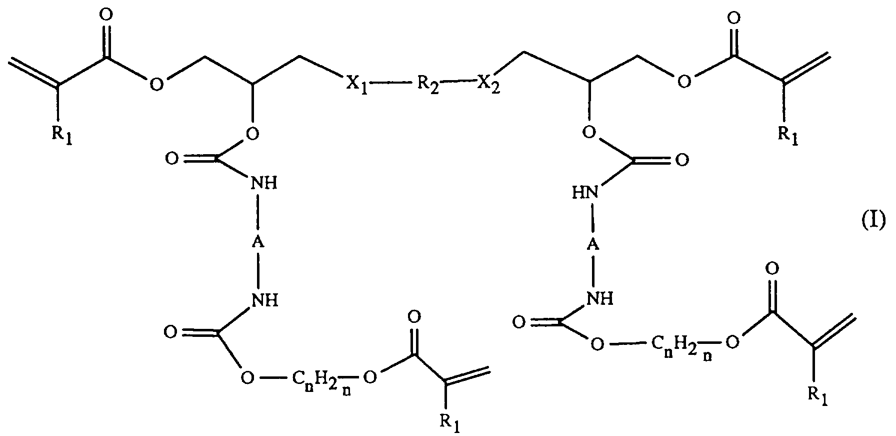 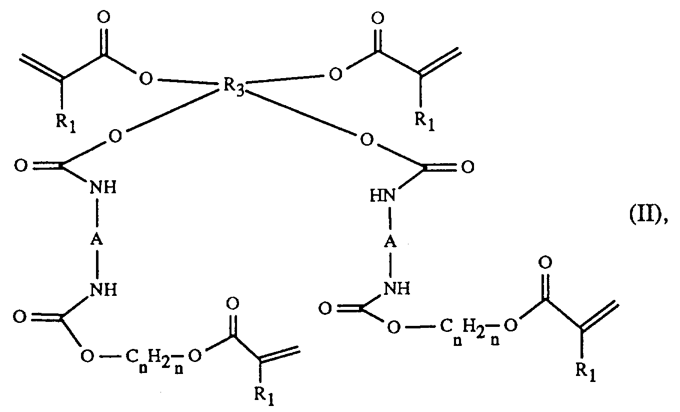 worin
R₁ für ein Wasserstoffatom oder Methyl steht,
X₁ und X₂ unabhängig voneinander je für -O- oder -CO-O- stehen,
R₂ einen zweiwertigen aliphatischen, cycloaliphatischen oder aromatischen Rest einer keine Glycidylether- oder -estergruppen mehr aufweisenden Diglycidylverbindung bedeutet,
A einen zweiwertigen aliphatischen, cycloaliphatischen oder aromatischen Rest einer keine Isocyanatgruppen mehr aufweisenden Diisocyanatverbindung darstellt,
n für eine ganze Zahl von 1 bis 8 steht und
R₃ einen vierwertigen cycloaliphatischen Rest einer keine am cycloaliphatischen Ring mehr gebundenen 1,2-Epoxidgruppe aufweisenden Diepoxidverbindung bedeutet,
(b) mindestens eine flüssige von der Komponente (a) verschiedene radikalisch polymierisierbare Verbindung und
(c) einen radikalischen Photoinitiator.

Vorzugsweise enthalten die erfindungsgemässen Gemische als Komponente (a) ein Tetraacrylat der Formel I oder II, worin
R₁ für ein Wasserstoffatom oder Methyl steht,
X₁ und X₂ je für -O- oder -CO-O- stehen,
R₂ einen zweiwertigen, linearen oder verzweigten Kohlenwasserstoffrest mit bis zu 20 C-Atomen, einen Rest der Formeln -(Alkylen-O)ₘ-Alkylen-, wobei das Alkylen 1 bis 8 C-Atome enthält und m für null oder eine ganze Zahl von 1 bis 100 steht, ferner 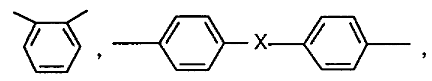 wobei X für ein lineares oder verzweigtes Alkylen mit 1 bis 6 C-Atomen steht, 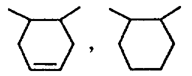 oder 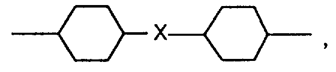 wobei X die zuvorgenannte Bedeutung hat, bedeutet,
A einen zweiwertigen aliphatischen Kohlenbwasserstoffrest mit bis zu 6 C-Atomen, einen unsubstituierten oder methylsubstituierten Phenylenrest, einen Rest der Formeln 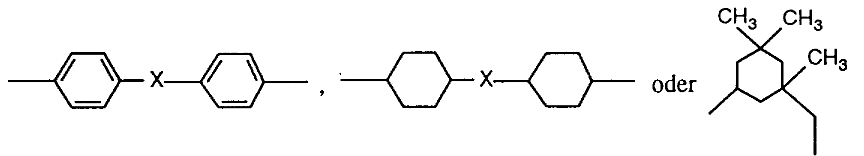 bedeutet, wobei X die zuvorgenannte Bedeutung hat, und
R₃ einen Rest der Formeln 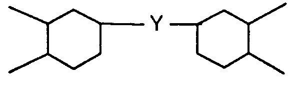 oder 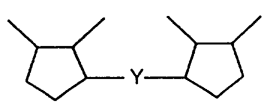 bedeutet, wobei Y für -CO-O-CH₂-, -CO-O-(CH₂)ₚ-O-CO- oder -CH₂-O-CO-(CH₂)ₚ-CO-O-CH₂- steht und p eine ganze Zahl von 2 bis 12 bedeutet.

Die Tetraacrylate der Formel I oder II stellen zum Teil bekannte Verbindungen dar und werden in JP 54/022498 beschrieben, wobei dort allgemein Umsetzungsprodukte von Diepoxiden mit Acrylsäure, Diisocyanaten und Hydroxyalkylacrylaten beschrieben werden.

Die Tetraacrylate der Formel I oder II können in einfacher Weise hergestellt werden, indem man beispielsweise einen aliphatischen, cycloaliphatischen oder aromatischen Diglycidylether oder -ester oder eine cycloaliphatische Diepoxidverbindung, worin die Epoxidgruppen einen Teil eines alicyclischen Ringsystems bilden, mit (Meth)acrylsäure im Molverhältnis 1:2 zum entsprechenden Epoxydiacrylat umsetzt, dieses dann mit einer aliphatischen, cycloaliphatischen oder aromatischen Diisocyanatverbindung im Molverhältnis 1:2 umsetzt, und das erhaltenen Additionsprodukt mit einem Hydroxyalkylacrylat der Formel III 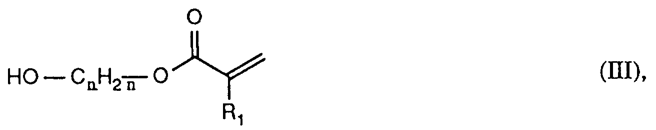 im Molverhältnis 1:2 umsetzt, worin R₁ für ein Wasserstoffatom oder Methyl steht und n für eine ganze Zahl von 1 bis 8 steht.

Als aliphatische, cycloaliphatische oder aromatische Diglycidylether können beispielsweise die in bekannter Weise durch Umsetzung von acyclischen Diolen, wie Ethylenglykol, Diethylenglykol und höheren Poly-(oxyethylen)-glykolen, Propan-1,2-diol oder Poly-(oxypropylen)-glykolen, Propan-1,3-diol, Butan-1,4-diol, Poly-(oxytetramethylen)-glykolen, Pentan-1,5-diol oder Hexan-1,6-diol, von cycloaliphatischen Alkoholen, wie 1,4-Cyclohexandimethanol, Bis-(4-hydroxycyclohexyl)-methan, 2,2-Bis-(4-hydroxycyclohexyl)-propan, N,N-Bis-(2-hydroxyethyl)-anilin oder p,p'-Bis-(2-hydroxyethylamino)-diphenylmethan, oder von zweiwertigen Phenolen, wie beispielsweise Resorcin oder Hydrochinon, oder zweiwertigen, mehrkernigen Phenolen, wie beispielsweise Bis-(4-hydroxyphenyl)-methan, 4,4'-Dihydroxybiphenyl, Bis-(4-hydroxyphenyl)-sulfon, 2,2-Bis-(4-hydroxyphenyl)-propan oder 2,2-Bis-(3,5-dibrom-4-hydroxyphenyl)-propan mit Epichlorhydrin oder β-Methylepichlorhydrin erhaltenen Epoxidharze eingesetzt werden. Solche Produkte sind bekannt und zum Teil im Handel erhältlich.

Als aliphatische, cycloaliphatische oder aromatische Diglycidylester können die durch Umsetzung von aliphatischen cycloaliphatischen oder aromatischen Dicarbonsäuren, wie beispielsweise Oxalsäure, Bernsteinsäure, Glutarsäure, Adipinsäure, Pimelinsäure, Korksäure, Azelainsäure, dimerisierte bzw. trimerisierte Linolsäure, Tetrahydrophthalsäure, 4-Methyltetrahydrophthalsäure, Hexahydrophthalsäure, 4-Methylhexahydrophthalsäure, Phthalsäure, Isophthalsäure oder Terephthalsäure, mit Epichlorhydrin oder β-Methylepichlorhydrin erhaltenen Epoxidharze eingesetzt werden. Solche Produkte ebenfalls sind bekannt und zum Teil im Handel erhältlich.

Es können auch Diepoxidverbindungen eingesetzt werden, die sowohl eine Glycidyletherals auch eine Glycidylestergruppe im Molekül enthalten. Solche Verbindung werden in bekannter Weise durch Glycidylierung von Hydroxycarbonsäuren, wie beispielsweise Salicylsäure, erhalten.

Als cycloaliphatische Diepoxidverbindungen, worin die Epoxidgruppen einen Teil eines alicyclischen Ringsystems bilden, sind beispielsweise Bis-(2,3-epoxycyclopentyl)-ether, 1,2-Bis-(2,3-epoxycyclopentyloxy)-ethan, 3,4-Epoxycyclohexylmethyl-3,4-epoxycyclohexancarboxylat, 3,4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)hexandioat, Ethylenbis-(3,4-epoxycyclohexancarboxylat), Ethandioldi-(3,4-epoxycyclohexylmethyl)-ether, Dicyclopentadiendiepoxid oder 2-(3,4-Epoxycyclohexyl-5,5-spiro-3,4-epoxy)cyclohexan-1,3-dioxan geeignet. Solche Diepoxidverbindungen sind ebenfalls bekannt und zum Teil im Handel erhältlich.

Als aliphatisches, cycloaliphatisches oder aromatisches Diisocyanat eignen sich beispielsweise Hexamethylendiisocyanat, Trimethylhexamethylendiisocyanat, Cyclohexandiisocyanat, Isophorondiisocyanat (3,5,5-Trimethyl-1-isocyanato-3-isocyanatomethylcyclohexan), Methylendicyclohexyldiisocyanat, p-Phenylendiisocyanat, 2,4-Diisocyanatotoluol, 2,6-Diisocyanatotoluol und technische Gemische von beiden Isomeren, Naphthylendiisocyanate, insbesondere 1,5-Naphthylendiisocyanat, Dianisidindiisocyanat, Methylendiphenyldiisocyanat, insbesondere das 4,4'-Isomere, aber auch technische Gemische verschiedener Isomeren, beispielsweise der 4,4'- und 2,4'-Isomeren, oder Polymethylenpolyphenylendiisocyanate.

Die Hydroxyalkylacrylate der Formel III stellen ebenfalls bekannte Verbindungen dar.

In den erfindungsgemässen Gemischen können als Komponente (b) die üblichen radikalisch polymerisierbaren Verbindungen verwendet werden, wie beispielsweise Monoacrylate, Di- und Polyacrylate mit einer Acrylatfunktionalität bis zu 9, sowie Vinyl-Verbindungen mit einer Vinylfunktionalität bis zu 6.

Als Monoacrylate eignen sich beispielsweise Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecylacrylat und -methacrylat, 2-Hydroxyethyl-, 2- und 3-Hydroxypropylacrylat und -methacrylat, 2-Methoxyethyl-, 2-Ethoxyethyl- und 2- oder 3-Ethoxypropylacrylat, Tetrahydrofurfurylmethacrylat, 2-(2-Ethoxyethoxy)ethylacrylat, Cyclohexylmethacrylat, 2-Phenoxyethylacrylat, Glycidylacrylat und Isodecylacrylat, sowie als Mono-N-vinylverbindung N-Vinylpyrrolidon oder N-Vinylcaprolactam. Solche Produkte sind ebenfalls bekannt und zum Teil im Handel erhältlich, zum Beispiel von der Firma SARTOMER Company.

Als Diacrylate für die Komponente (b) eignen sich beispielsweise die Diacrylate von cycloaliphatischen oder aromatischen Diolen, wie 1,4-Dihydroxymethylcyclohexan, 2,2-Bis-(4-hydroxycyclohexyl)-propan, Bis-(4-hydroxycyclohexyl)-methan, Hydrochinon, 4,4'-Dihydroxybiphenyl, Bisphenol A, Bisphenol F, Bisphenol S, ethoxyliertes oder propoxyliertes Bisphenol A, ethoxyliertes oder propoxyliertes Bisphenol F oder ethoxyliertes oder propoxyliertes Bisphenol S. Solche Diacrylate sind bekannt und zum Teil im Handel erhältlich.
Als Diacrylate können auch Verbindungen der Formel IV, V, VI oder VII 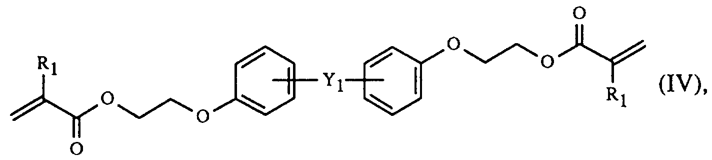 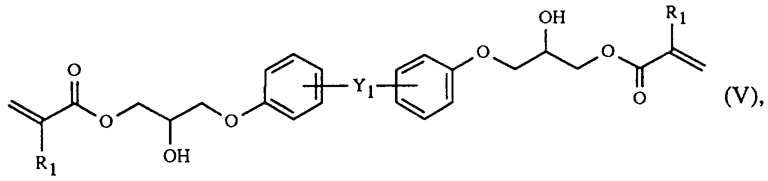 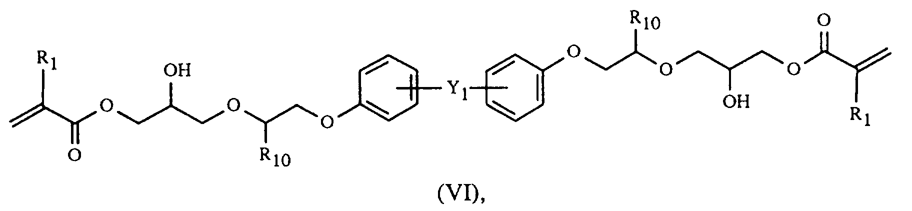 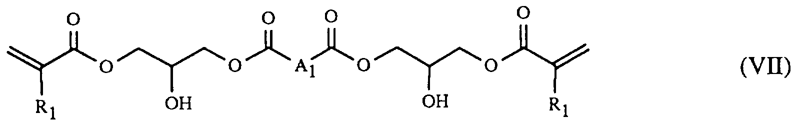 eingesetzt werden, worin R₁ ein Wasserstoffatom oder Methyl bedeutet, Y₁ für eine direkte Bindung, C₁-C₆-Alkylen, -S-, -O-, -SO-, -SO₂- oder -CO- steht,
- R₁₀: für eine C₁-C₈-Alkylgruppe, eine unsubstituierte oder durch eine oder mehrere C₁-C₄-Alkylgruppen, Hydroxygruppen oder Halogenatome substituierte Phenylgruppe, oder für einen Rest der Formel -CH₂-OR₁₁ steht, worin
- R₁₁: eine C₁-C₈-Alkylgruppe oder Phenylgruppe bedeutet und
- A₁: einen Rest der Formeln 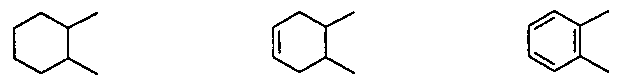 darstellt.

Die Diacrylate der Formeln IV und V sind bekannt und zum Teil im Handel erhältlich, beispielsweise unter der Bezeichung SR®349 oder Novacure®3700, und können hergestellt werden, indem man ethoxylierte Bisphenole, insbesondere ethoxyliertes Bisphenol A, oder Bisphenoldiglycidylether, insbesondere Bisphenol A-diglycidylether, mit (Meth)acrylsäure zu den Verbindungen der Formeln IV oder V umsetzt.

In gleicher Weise können die Verbindungen der Formeln VI und VII hergestellt werden, indem man einen Diglycidylether der Formel VIa 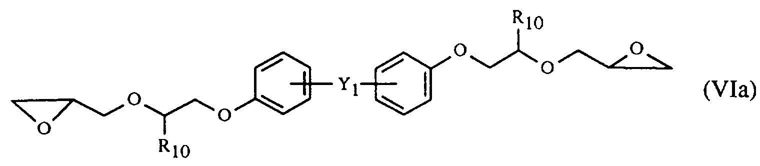 oder einen Diglycidylester der Formel VIIa 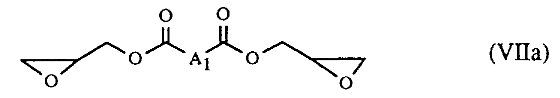 mit (Meth)acrylsäure zu den Verbindungen der Formel VI oder VII umsetzt, wobei R₁₀, Y₁ und A₁ die oben angegebene Bedeutung haben.

Ferner können als Diacrylate auch eine Verbindung der Formel VIII, IX, X oder XI 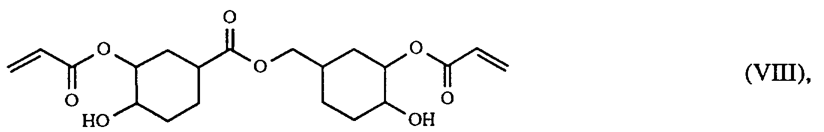 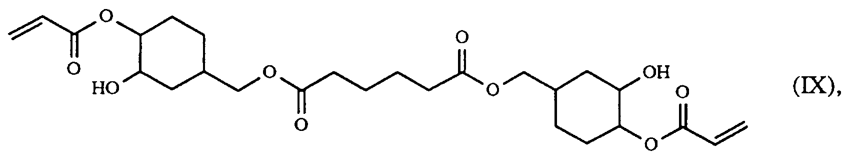 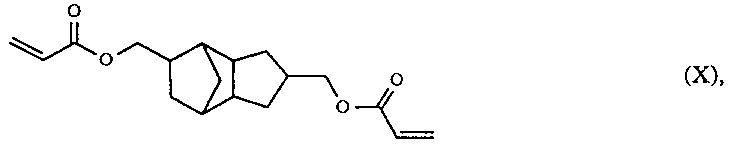 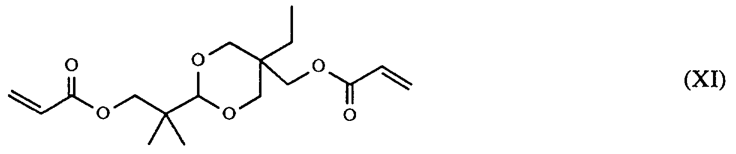 verwendet werden. Diese Verbindungen sind bekannt und zum Teil im Handel erhältlich. Beispielsweise können die Verbindungen der Formeln VIII und IX in bekannter Weise durch Umsetzen der cycloaliphatischen Diepoxide der Formeln VIIIa und IXa 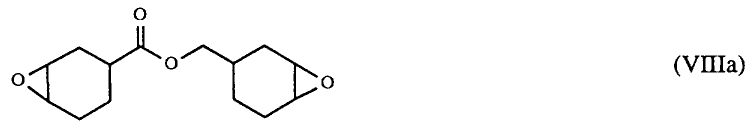 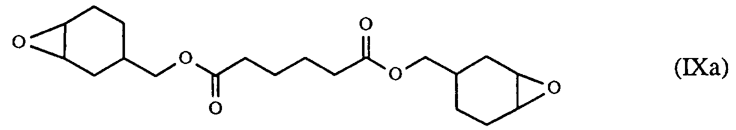 mit (Meth)acrylsäure zu den Verbindungen der Formeln VIII oder IX erhalten werden. Die Verbindung der Formel XI ist im Handel unter der Bezeichung Kayarad®R-604 erhältlich.

Die in den erfindungsgemässen Gemischen als Komponente (b) verwendeten flüssigen Poly(meth-)acrylate mit einer (Meth-)Acrylatfunktionalität von grösser als 2 können beispielsweise tri-, tetra- oder pentafunktionelle monomere oder oligomere aliphatische, cycloaliphatische oder aromatische Acrylate oder Methacrylate sein.

Als aliphatische polyfunktionelle (Meth-)Acrylate eignen sich beispielsweise die Triacrylate und Trimethacrylate von Hexan-2,4,6-triol, Glycerin oder 1,1,1-Trimethylolpropan, ethoxyliertes oder propoxyliertes Glycerin oder 1,1,1-Trimethylolpropan und die hydroxygruppenhaltigen Tri(meth-)acrylate, die durch Umsetzung von Triepoxidverbindungen, wie beispielsweise die Triglycidylether von den genannten Triolen, mit (Meth-)Acrylsäure erhalten werden. Weiterhin können zum Beispiel Pentaerythritoltetraacrylat, Bistrimethylolpropantetraacrylat, Pentaerythritolmonohydroxytriacrylat oder -methacrylat oder Dipentaerythritolmonohydroxypentaacrylat oder -methacrylat verwendet werden.

Ausserdem können als Komponente (b) hexafunktionelle oder höherfunktionelle Urethanacrylate oder Urethanmethacrylate verwendet werden. Diese Urethan(meth-)acrylate sind dem Fachmann bekannt und können in bekannter Weise hergestellt werden, indem man beispielsweise ein hydroxylterminiertes Polyurethan mit Acrylsäure oder Methacrylsäure umsetzt, oder indem man ein isocyanatterminiertes Präpolymer mit Hydroxyalkyl(meth)acrylaten zum Urethan(meth-)acrylat umsetzt.

Als aromatische Tri(meth-)acrylate eignen sich beispielsweise die Umsetzungsprodukte aus Triglycidylethern dreiwertiger Phenole und drei Hydroxylgruppen aufweisende Phenol- oder Kresolnovolake mit (Meth)-Acrylsäure.

Vorzugsweise enthalten die erfindungsgemässen Gemische als Komponente (b) mindestens ein flüssiges, von der Komponente (a) verschiedenes (Meth)acrylat mit einer Acrylatfunktionalität von 1 bis 9.

Insbesondere enthalten die erfindungsgemässen Gemische als Komponente (b) eine flüssige Mischung aus aromatischen, aliphatischen oder cycloaliphatischen (Meth)acrylaten mit einer Acrylatfunktionalität von 1 bis 9.

Besonders bevorzugt enthalten die erfindungsgemässen Gemische als Komponente (b) eine flüssige Mischung aus mindestens einem Polyalkylenglykol(meth)acrylat und mindestens einem aromatischen, aliphatischen oder cycloaliphtischen (Meth)Acrylat mit einer Acrylatfunktionalität von 1 bis 9.

In den erfindungsgemässen Zusammensetzungen können als Komponente (c) alle Typen von Photoinitiatoren eingesetzt werden, welche bei der entsprechenden Bestrahlung freie Radikale bilden. Typische Verbindungen bekannter Photoinitiatoren sind Benzoine, wie Benzoin, Benzoinether, wie Benzoinmethylether, Benzoinethylether und Benzoinisopropylether, Benzoinphenylether und Benzoinacetat, Acetophenone, wie Acetophenon, 2,2-Dimethoxyacetophenon und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert-Butylanthrachinon, 1-Chloranthrachinon und 2-Amylanthrachinon, ferner Triphenylphosphin, Benzoylphosphinoxide, wie beispielsweise 2,4,6-Trimethylbenzoyldiphenylphosphinoxid (Luzirin TPO), Benzophenone, wie Benzophenon und 4,4'-Bis-(N,N'-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton, welche alle bekannte Verbindungen darstellen.

Besonders geeignete Photoinitiatoren, welche gewöhnlich in Kombination mit einem He/Cd-Laser als Lichtquelle verwendet werden, sind Acetophenone, wie 2,2-Dialkoxybenzophenone und 1-Hydroxyphenylketone, beispielsweise 1-Hydroxycyclohexylphenylketon oder 2-Hydroxyisopropylphenylketon (= 2-Hydroxy-2,2-dimethylacetophenon), insbesondere aber 1-Hydroxycyclohexylphenylketon.

Eine andere Klasse von Photoinitiatoren (c), die gewöhnlich bei Verwendung von Argon-ion-Lasern eingesetzt wird, sind die Benzilketale, wie beispielsweise Benzildimethylketal. Insbesondere verwendet man als Photoinitiator ein α-Hydroxyphenylketon, Benzildimethylketal oder 2,4,6-Trimethylbenzoyldiphenylphosphinoxid.

Eine weitere Klasse von geeigneten Photoinitiatoren (c) stellen die ionischen Farbstoff-Gegenionverbindungen (ionic dye-counter ion compound) dar, welche in der Lage sind, aktinische Strahlen zu absorbieren und freie Radikale zu erzeugen, die die Polymerisation der Acrylate initiieren können. Die erfindungsgemässen Zusammensetzungen, welche ionische Farbstoff-Gegenionverbindungen enthalten, können auf diese Weise variabler mit sichtbarem Licht im einstellbaren Wellenlängenbereich von 400-700 nm gehärtet werden. Ionische Farbstoff-Gegenionverbindungen und deren Wirkungsweise sind bekannt, beispielsweise aus EP-A 223 587 und den US-Patenten 4,751,102, 4,772,530 und 4,772,541. Als Beispiele für geeignete ionische Farbstoff-Gegenionverbindungen seien genannt die anionischen Farbstoff-Jodoniumionkomplexe, die anionischen Farbstoff-Pyrylliumionkomplexe und insbesondere die kationischen Farbstoff-Boratanionverbindungen der folgenden Formel 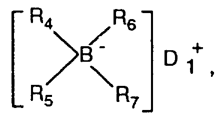 worin D₁ ⁺ für einen kationischen Farbstoff steht und R₄, R₅, R₆ und R₇ unabhängig voneinander je ein Alkyl, Aryl, Alkaryl, Allyl, Aralkyl, Alkenyl, Alkinyl, eine alicyclische oder gesättigte oder ungesättigte heterocyclische Gruppe bedeuten. Bevorzugte Definitionen für die Reste R₄ bis R₇ können beispielsweise aus EP-A-0 223 587 entnommen werden.

Die Photoinitiatoren werden bekanntlich in wirksamen Mengen zugesetzt, das heisst, in Mengen von 0,1 bis 10 Gewichtsprozent, bezogen auf die Gesamtmenge der Zusammensetzung. Wenn die erfindungsgemässen Zusammensetzungen für stereolithographische Verfahren verwendet werden, wobei normalerweise Laserstrahlen eingesetzt werden, ist es wesentlich, dass die Absorptionsfähigkeit der Zusammensetzung durch Typ und Konzentration der Photoinitiatoren so abgestimmt wird, dass die Härtungstiefe bei normaler Lasergeschwindigkeit ungefähr 0,1 bis 2,5 mm beträgt.

Vorzugsweise enthalten die erfindungsgemässen Gemische als Photoinitiator (c) ein 1-Hydroxyphenylketon, insbesondere 1-Hydroxycyclohexylphenylketon.

In den erfindungsgemässen Gemischen sind vorzugsweise
5 bis 75 Gewichts-% einer Verbindung der Formeln I oder II als Komponente (a),
25 bis 95 Gewichts-% der Komponente (b), wobei die Menge der Komponenten (a) und (b) zusammen 100 Gewichts-% beträgt, und
0,1 bis 10 Gewichts-%, bezogen auf die Menge (a) und (b), der Komponente (c) enthalten.

Insbesondere enthalten die erfindungsgemässen Gemische
10 bis 50 Gewichts-% einer Verbindung der Formeln I oder II als Komponente (a),
50 bis 90 Gewichts-% der Komponente (b), wobei die Menge der Komponenten (a) und (b) zusammen 100 Gewichts-% beträgt, und
0,1 bis 10 Gewichts-%, bezogen auf die Menge (a) und (b), der Komponente (c) .

Falls erwünscht können den erfindungsgemässen Gemischen die üblichen Additive zugesetzt werden, beispielsweise Stabilisatoren, wie UV-Stabilisatoren, Polymerisationsinhibitoren, Trennmittel, Benetzungsmittel, Verlaufsmittel, Sensibilisatoren, Antiabsetzmittel, oberflächenaktive Mittel, Farbstoffe, Pigmente oder Füllstoffe.

Die erfindungsgemässen Ggemische können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter, zweckmässig in Abwesenheit von Licht und gegebenenfalls bei leicht erhöhter Temperatur.

Die erfindungsgemässen, photoempfindlichen Gemische können durch Bestrahlen mit aktinischem Licht, beispielsweise mittels Elektronenstrahlen, Röntgenstrahlen, UV- oder VIS-Licht, das heisst, mit elektromagnetischer Strahlung oder Teilchenstrahlung im Wellenlängenbereich von 280-650 nm, polymerisiert werden. Besonders geeignet sind Laserstrahlen von He/Cd-, Argon- oder Stickstoff- sowie Metalldampf- und NdYAG-Lasern mit vervielfachter Frequenz. Es ist dem Fachmann bekannt, dass für jede gewählte Lichtquelle die geeigneten Photoinitiatoren ausgewählt und gegebenenfalls sensibilisiert werden müssen. Man hat erkannt, dass die Eindringtiefe der Strahlung in die zu polymerisierende Zusammensetzung und die Arbeitsgeschwindigkeit in direktem Zusammenhang mit dem Absorptionskoeffizienten und der Konzentration der Photoinitiatoren stehen.

Die erfindungsgemässen Gemische können auch verschiedene Photoinitiatoren enthalten, welche gegenüber Strahlen von Emissionslinien unterschiedlicher Wellenlänge verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Die erfindungsgemässen Gemische, die eine hohe und vergleichsweise verbesserte Photoempfindlichkeit aufweisen, eignen sich vorzugsweise zur Herstellung von dreidimensionalen Gegenständen nach dem stereolithographischen Verfahren und ergeben dabei Formkörper, die sich durch eine hohe Grünfestigkeit, einen hohen Elastizitätsmodul und gleichzeitig eine hohe Reissfestigkeit und eine hohe Schlagzähigkeit auszeichnen.

Gegenstand der Erfindung ist somit auch ein Verfahren zur Herstellung von dreidimensionalen Gegenständen aus den flüssigen, erfindungsgemässen Gemischen mittels eines lithographischen Verfahrens, wobei die Oberfläche einer Schicht aus dem erfindungsgemässen, flüssigen Gemisch ganzflächig oder in einem vorbestimmten Muster mit aktinischem Licht aus einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als UV/VIS-Lichtquelle vorzugsweise ein Laserstrahl verwendet, der in einer besonders bevorzugten Ausführungsform computergesteuert ist.

Werden die erfindungsgemässen Gemische als Beschichtungsmittel eingesetzt, so erhält man klare und harte Beschichtungen auf Holz, Papier, Metall, Keramik oder anderen Oberflächen. Die Beschichtungsdicke kann dabei sehr variieren und etwa von 1 µm bis etwa 1 mm betragen. Aus den erfindungsgemässen Gemischen können Reliefbilder für gedruckte Schaltungen oder Druckplatten direkt durch Bestrahlen der Gemische hergestellt werden, beispielsweise mittels eines computergesteuerten Laserstrahls geeigneter Wellenlänge oder unter Anwendung einer Photomaske und einer entsprechenden Lichtquelle.

Eine weitere Verwendungsmöglichkeit ist der Einsatz der erfindungsgemässen Gemische als photohärtbare Klebstoffe.

Vorzugsweise verwendet man die erfindungsgemässen Gemische zur Herstellung von photopolymerisierten Schichten, insbesondere in Form von dreidimensionalen Gegenständen, die aus mehreren aneinander haftenden, verfestigten Schichten aufgebaut sind.

Gegenstand vorliegender Erfindung sind auch die aus den erfindungsgemässen Gemischen durch Bestrahlen mit aktinischem Licht erhaltenen dreidimensionalen Gegenstände, die aus mehreren aneinander haftenden, verfestigten Schichten aufgebaut sind.

### Herstellung der Tetraacrylate

### Beispiel A (Tetraacrylat A)

Zu einer Lösung von 88,9 g (0,4 Mol) Isophorondiisocyanat (1-Cyanato-3-cyanatomethyl-3,5,5-trimethylcyclohexan), 0,16 g Zinnoktoat und 0,18 g Ralox® (2,2'-Methylen-bis-(4,6-di-tert.-butylphenol), Firma Raschig) werden bei 50°C 96,8 g (0,2 Mol) Novacure®3700 (Handelsprodukt der Firma Radcure), ein Diacrylat, das durch Umsetzung eines Bisphenol-A-digylcidylethers mit Acrylsäure im Molververhältnis von 1:2 erhältlich ist, langsam zugetropft, und die Reaktionslösung wird 5 Stunden (h) bei 55°C gerührt. Zu diesem Zeitpunkt besitzt die Reaktionslösung gemäss Titration einen Isocyanatgehalt von 2,2 Mol/kg (Theorie: 2,16 Mol/kg).
Anschliessend wird die Temperatur der Reaktionslösung auf 85°C erhöht, und es werden 52,8 g (0,41 Mol) Hydroxyethylacrylat (Fluka,90%ig rein) zugetropft. Die Reaktionslösung wird bis zum Verschwinden der Isocyanatgruppen weitergerührt. Nach 4 h Rühren besitzt das erhaltene Tetraacrylat gemäss Gelpermeationschromatographie (GPC) ein Molekulargewicht mit einem Zahlenmittel (Mn) von 1664. Der Quotient Mw/Mn aus dem Gewichtsmittel (Mw) und Mn des Molekulargewichtes beträgt 2,65. Das erhaltene Tetraacrylat entspricht der Formel

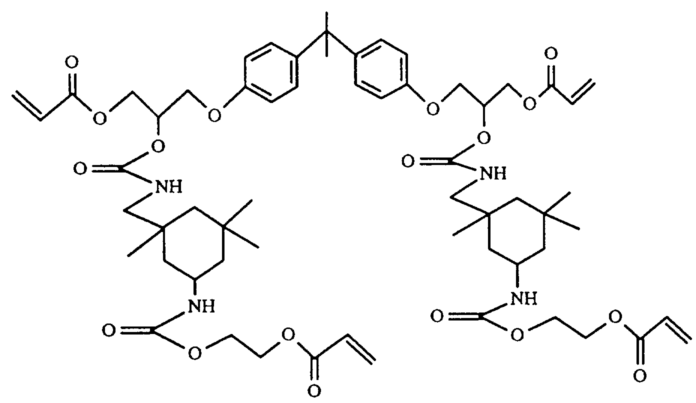

### Beispiel B (Tetraacrylat B)

Analog der bei der Herstellung von Tetraacrylat A angegebenen Arbeitsweise wird Tetraacrylat B hergestellt, indem man 88,9 g (0,4 Mol) Isophorondiisocyanat,
85,6 g (0,2 Mol) eines Diacrylates, das durch Umsetzung von Hexahydrophthalsäurediglycidylether mit Acrylsäure im Molverhältnis von 1:2 erhältlich ist, und
62 g (0,46 Mol) Hydroxyethylacrylat in Gegenwart von 0,16 g Zinnoktoat und 0,17 g Ralox® umgesetzt.
Das erhaltene Tetraacrylat besitzt gemäss GPC ein Mn von 1098, ein Mw/Mn von 1,66 und entspricht der Formel

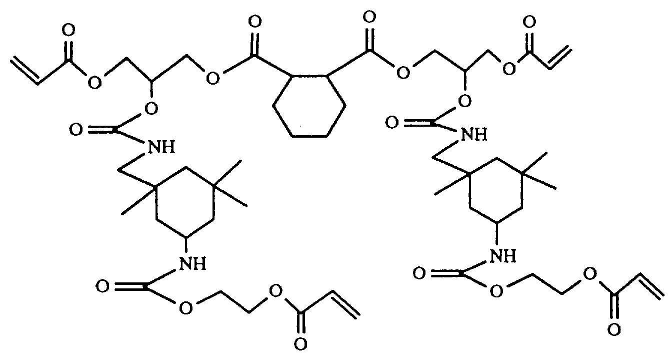

### Beispiel C (Tetraacrylat C)

Analog der bei der Herstellung von Tetraacrylat A angegebenen Arbeitsweise wird Tetraacrylat C hergestellt, indem man 88,9 g (0,4 Mol) Isophorondiisocyanat,
85,6 g (0,2 Mol) eines Diacrylates, das durch Umsetzung von Bis-(3,4-epoxycyclohexyl)-adipat mit Acrylsäure im Molverhältnis von 1:2 erhältlich ist, und
58 g (0,43 Mol) Hydroxyethylacrylat in Gegenwart von 0,16 g Zinnoktoat und 0,19 g Ralox® umgesetzt.
Das erhaltene Tetraacrylat besitzt gemäss GPC ein Mn von 1297, ein Mw/Mn von 3,67 und entspricht der Formel

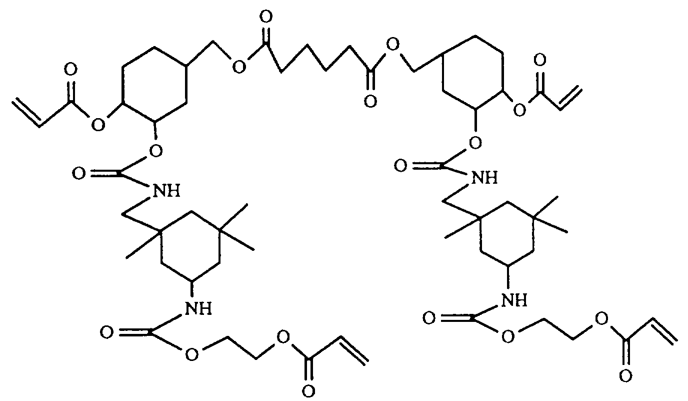

### Beispiel D (Tetraacrylat D)

Zu einer Lösung von 22,03 ml (0,15 Mol) 2,4-Toluylendiisocyanat und 0,05 g Ralox® werden bei 60°C 50,68 g eines Diacrylates, das durch Umsetzung eines Polypropylenglykoldiglycidylethers (MG des Polypropylenglykols = 400) mit Acrylsäure im Molverhältnis von 1:2 erhältlich ist (OH-Gehalt gemäss Titration: 2,96 Mol/kg), langsam zugetropft, und die Reaktionslösung wird 7 h bei 60°C gerührt. Zu diesem Zeitpunkt wird mittels Titration ein Isocyanatgehalt von 2,21 Mol/kg (Theorie 1,95 Mol/kg) bestimmt.
Dann wird die Temperatur der Reaktionslösung auf 40°C erniedrigt, und es werden 0,14 g Zinnoktoat und 19,73 ml (0,17 Mol) Hydroxyethylacrylat (Fluka;90%ig rein) zur Reaktionslösung zugetropft. Die Reaktionslösung wird bis zum Verschwinden der Isocyanatgruppen weitergerührt. Nach 5 h besitzt das erhaltene Tetraacrylat gemäss GPC ein Mn von 944 und ein Mw/Mn von 2,72.
Durch Mikrohydrierung in Gegenwart eines Pd/C-Katalysators (5 % Pd auf Kohle) in Dimethylacetamid werden 2,9 mMol H₂/g aufhydriert, ein Nachweis, dass 4 Acrylatgruppen im Molekül enthalten sind. Das erhaltene Tetraacrylat entspricht der Formel 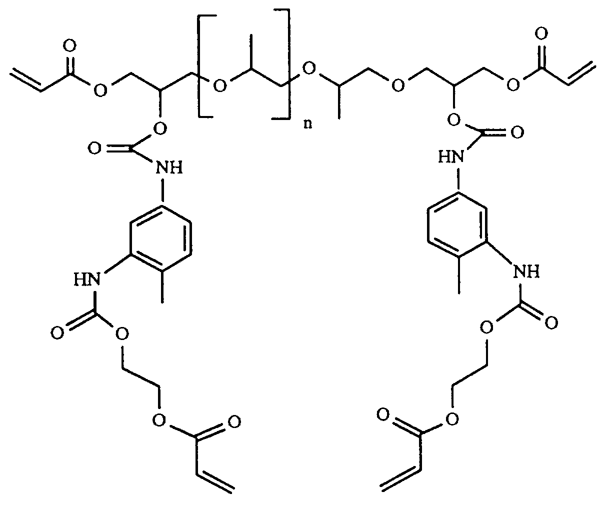 mit n = 6-7.

### Beispiel 1

35 g des im Beispiel A hergestellten Tetraacrylates A werden bei 60°C mit 20 g eines Polyethylenglykol(400)diacrylates (im Handel erhältliches Produkt SR®344 der Firma Sartomer), 30 g eines ethoxylierten Bisphenol A-dimethacrylates (SR®348 der Firma Sartomer) und 10 g Tripropylenglykoldiacrylat (SR®306 der Firma Sartomer) vermischt. Anschliessend werden 4,85 g 1-Hydroxycyclohexylphenylketon (Irgacure®184 der Firma CIBA-GEIGY) und 0,15 g Hydrochinonmonomethylether zugegeben, und das Gemisch wir solange gerührt, bis eine klare homogene Mischung entsteht.

Mit Hilfe eines He/Cd-Lasers mit einer Bestrahlungsenergie von 40 mJ/cm werden durch Bestrahlung der Mischung Formkörper hergestellt. Die durch Laserhärtung erhaltenen Formkörper (Grünlinge) weisen folgende Eigenschaften auf:
- Elastizitätsmodul (E-Modul) gemäss DIN 53371 =: 86 N/mm.
- Reissdehnung gemäss DIN 53455 =: 17 %.

Zur vollständigen Aushärtung werden die Grünlinge 30 Minuten (min) mit UV-Licht bestrahlt. Die so erhaltenen Formkörper weisen folgende Eigenschaften auf:
- E-Modul =: 2289 N/mm.
- Reissdehnung =: 8%.

Die Dimension der Formkörper beträgt typischerweise:
- Länge=: 50 mm;
- Querschnitt =: 1,2 x 0,3 mm.

Die Reissfestigkeit der Formkörper wird mit der Zugtestmaschine Lloyd®500 der Firma Lloyd bestimmt.

### Beispiel 2

In gleicher Weise wie in Beispiel 1 wird bei 60°C aus 35 g des im Beispiel B hergestellten Tetraacrylates B, 20 g SR®344, 30 g SR®348, 10 g SR®306, 4,85 g Irgacure 184 und 0,15 g Hydrochinonmonomethylether eine klare homogene Mischung hergestellt. Die durch analoge Bestrahlung der Mischung mit dem He/Cd-Laser erhaltenen Grünlinge weisen folgende Eigenschaften auf:
- E-Modul (DIN 53371)=: 30 N/mm;
- Reissdehnung (DIN 53455)=: 19%.

Die mittels 30 min lange UV-Bestrahlung ausgehärteten Formkörper weisen folgende Eigenschaften auf:
- E-Modul (DIN 53371)=: 2087 N/mm;
- Reissdehnung (DIN 53455)=: 5%.

Zur Bestimmung der Schlagzähigkeit wird die oben hergstellte photopolymerisierbare Mischung zwischen zwei Glasplatten im Abstand von 4 mm gegossen und 30 min lang durch Bestrahlen mit UV-Licht ausgehärtet. Es werden Prüfkörper der Abmessung 50 x 10 x 4 mm hergestellt.
- Schlagzähigkeit (DIN 52453)=: 14 kJ/m.

### Beispiel 3

In gleicher Weise wie in Beispiel 1 wird bei 60°C aus 35 g des im Beispiel C hergestellten Tetraacrylates C, 20 g SR®344, 30 g SR®348, 10 g SR®306, 4,85 g Irgacure 184 und 0,15 g Hydrochinonmonomethylether eine klare homogene Mischung hergestellt. Die durch analoge Bestrahlung der Mischung mit dem He/Cd-Laser erhaltenen Grünlinge weisen folgende Eigenschaften auf:
- E-Modul (DIN 53371)=: 16 N/mm;
- Reissdehnung (DIN 53455)=: 16%.

Die mittels 30 min lange UV-Bestrahlung ausgehärteten Formkörper weisen folgende Eigenschaften auf:
- E-Modul (DIN 53371)=: 2012 N/mm;
- Reissdehnung (DIN 53455)=: 6%.

Zur Bestimmung der Schlagzähigkeit wird die oben hergestellte photopolymerisierbare Mischung zwischen zwei Glasplatten im Abstand von 4 mm gegossen und 30 min lang durch Bestrahlen mit UV-Licht ausgehärtet. Es werden Prüfkörper der Abmessung 50 x 10 x 4 mm hergestellt.
- Schlagzähigkeit (DIN 52453) =: 14 kJ/m.

## Patentansprüche

1. Verwendung von Tetraacrylaten der Formel I oder II 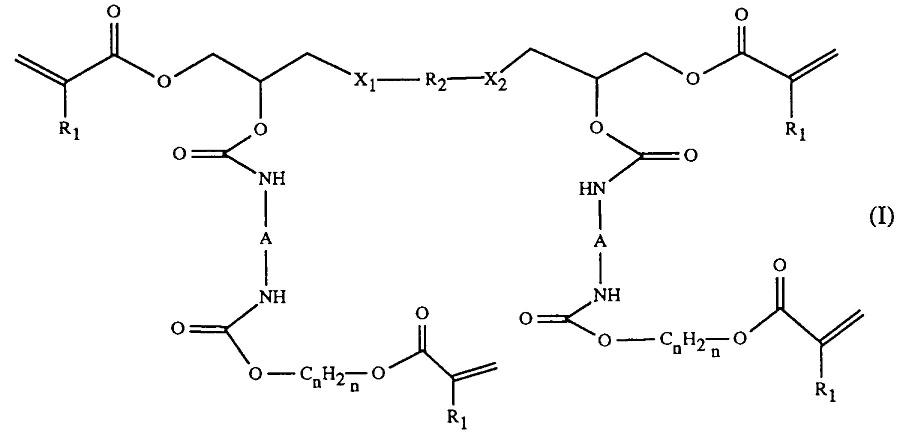 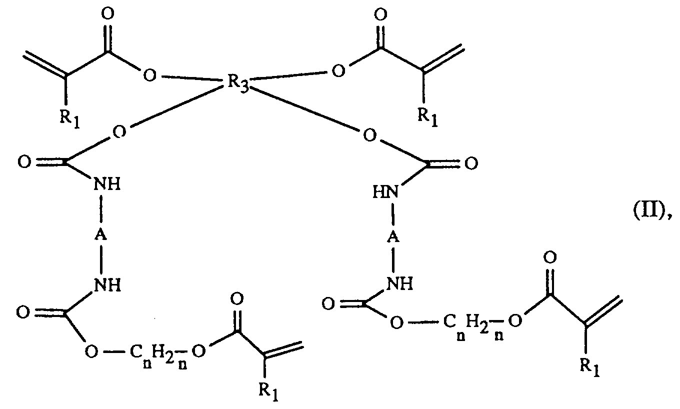 worin
R₁ für ein Wasserstoffatom oder Methyl steht,
X₁ und X₂ unabhängig voneinander je für -O- oder -CO-O- stehen,
R₂ einen zweiwertigen aliphatischen, cycloaliphatischen oder aromatischen Rest einer keine Glycidylether- oder -estergruppen mehr aufweisenden Diglycidylverbindung bedeutet,
A einen zweiwertigen aliphatischen, cycloaliphatischen oder aromatischen Rest einer keine Isocyanatgruppen mehr aufweisenden Diisocyanatverbindung darstellt,
n für eine ganze Zahl von 1 bis 8 steht und
R₃ einen vierwertigen cycloaliphatischen Rest einer keine am cycloaliphatischen Ring mehr gebundenen 1,2-Epoxidgruppe aufweisenden Diepoxidverbindung bedeutet, als Formulierungskomponente für Photopolymerisierbare Harzgemische, die in stereolithographische Verfahren eingesetzt werden.

2. Verwendung gemäss Anspruch 1, worin in Formel I und II
R₁ für ein Wasserstoffatom oder Methyl steht,
X₁ und X₂ je für -O- oder -CO-O- stehen,
R₂ einen zweiwertigen, linearen oder verzweigten Kohlenwasserstoffrest mit bis zu 20 C-Atomen, einen Rest der Formeln -(Alkylen-O)ₘ-Alkylen-, wobei das Alkylen 1 bis 8 C-Atome enthält und m für null oder eine ganze Zahl von 1 bis 100 steht, ferner 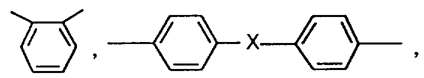 wobei X für ein lineares oder verzweigtes Alkylen mit 1 bis 6 C-Atomen steht, 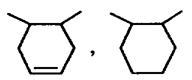 oder 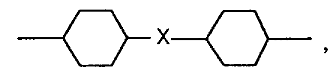 wobei X die zuvorgenannte Bedeutung hat, bedeutet,
A einen zweiwertigen aliphatischen Kohlenwasserstoffrest mit bis zu 6 C-Atomen, einen unsubstituierten oder methylsubstituierten Phenylenrest, einen Rest der Formeln 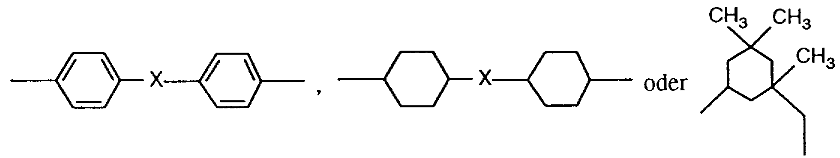 bedeutet, wobei X die zuvorgenannte Bedeutung hat, und
R₃ einen Rest der Formeln 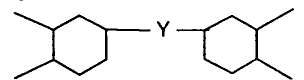 oder 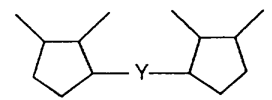 bedeutet, wobei Y für -CO-O-CH₂-, -CO-O-(CH₂)_{P}-O-CO- oder -CH₂-O-CO-(CH₂)_{P}-CO-O-CH₂- steht und p eine ganze Zahl von 2 bis 12 bedeutet.

3. Photopolymerisierbare Gemische, enthaltend
(a) ein Tetraacrylat der Formel I oder II 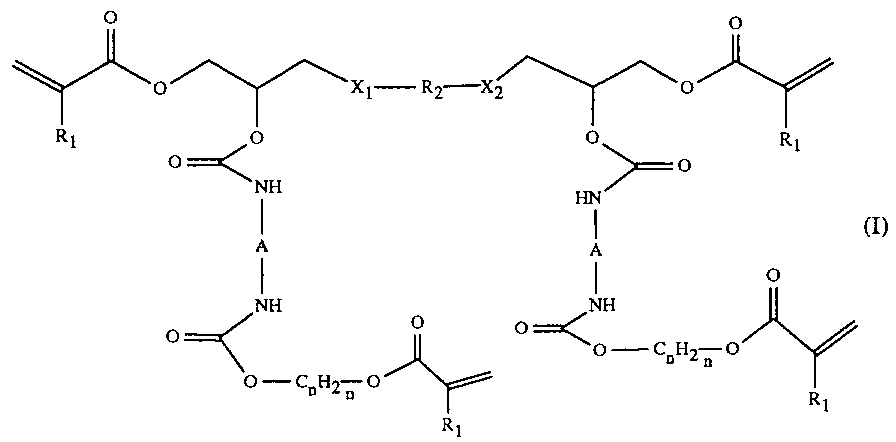 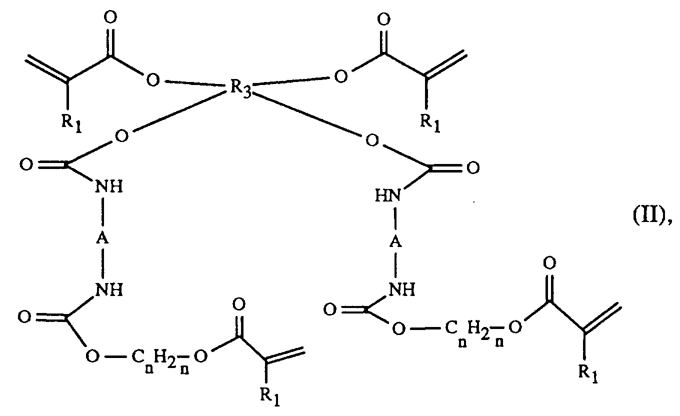 worin
R₁ für ein Wasserstoffatom oder Methyl steht,
X₁ und X₂ unabhängig voneinander je für -O- oder -CO-O- stehen,
R₂ einen zweiwertigen aliphatischen, cycloaliphatischen oder aromatischen Rest einer keine Glycidylether- oder -estergruppen mehr aufweisenden Diglycidylverbindung bedeutet,
A einen zweiwertigen aliphatischen, cycloaliphatischen oder aromatischen Rest einer keine Isocyanatgruppen mehr aufweisenden Diisocyanatverbindung darstellt,
n für eine ganze Zahl von 1 bis 8 steht und
R₃ einen vierwertigen cycloaliphatischen Rest einer keine am cycloaliphatischen Ring mehr gebundenen 1,2-Epoxidgruppe aufweisenden Diepoxidverbindung bedeutet,
(b) mindestens eine flüssige von der Komponente (a) verschiedene radikalisch polymierisierbare Verbindung und
(c) einen radikalischen Photoinitiator.

4. Gemische gemäss Anspruch 3, enthaltend als Komponente (a) ein Tetraacrylat der Formel I oder II, worin
R₁ für ein Wasserstoffatom oder Methyl steht,
X₁ und X₂ je für -O- oder -CO-O- stehen,
R₂ einen zweiwertigen, linearen oder verzweigten Kohlenwasserstoffrest mit bis zu 20 C-Atomen, einen Rest der Formeln -(Alkylen-O)ₘ-Alkylen-, wobei das Alkylen 1 bis 8 C-Atome enthält und m für null oder eine ganze Zahl von 1 bis 100 steht, ferner 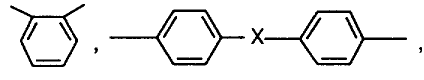 wobei X für ein lineares oder verzweigtes Alkylen mit 1 bis 6 C-Atomen steht, 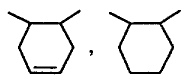 oder 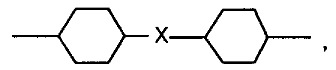 wobei X die zuvorgenannte Bedeutung hat, bedeutet,
A einen zweiwertigen aliphatischen Kohlenbwasserstoffrest mit bis zu 6 C-Atomen, einen unsubstituierten oder methylsubstituierten Phenylenrest, einen Rest der Formeln 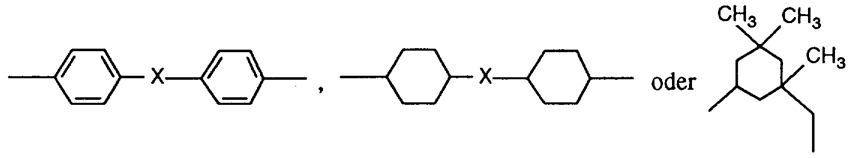 bedeutet, wobei X die zuvorgenannte Bedeutung hat, und
R₃ einen Rest der Formeln 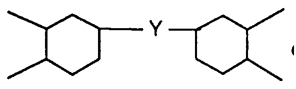 oder 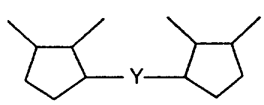 bedeutet, wobei Y für -CO-O-CH₂-, -CO-O-(CH₂)ₚ-O-CO- oder -CH₂-O-CO-(CH₂)ₚ-CO-O-CH₂- steht und p eine ganze Zahl von 2 bis 12 bedeutet.

5. Gemische gemäss Anspruch 3, enthaltend als Komponente (b) mindestens ein flüssiges, von der Komponente (a) verschiedenes (Meth)acrylat mit einer Acrylatfunktionalität von 1 bis 9.

6. Gemische gemäss Anspruch 3, enthaltend als Komponente (b) eine flüssige Mischung aus aromatischen, aliphatischen oder cycloaliphatischen (Meth)acrylaten mit einer Acrylatfunktionalität von 1 bis 9.

7. Gemische gemäss Anspruch 3, enthaltend als Komponente (b) eine flüssige Mischung aus mindestens einem Polyalkylenglykol(meth)acrylat und mindestens einem aromatischen, aliphatischen oder cycloaliphtischen (Meth)Acrylat mit einer Acrylatfunktionalität von 1 bis 9.

8. Gemische gemäss Anspruch 3, enthaltend
5 bis 75 Gewichts-% einer Verbindung der Formeln I oder II als Komponente (a),
25 bis 95 Gewichts-% der Komponente (b), wobei die Menge der Komponenten (a) und (b) zusammen 100 Gewichts-% beträgt, und
0,1 bis 10 Gewichts-%, bezogen auf die Menge (a) und (b), der Komponente (c).

9. Gemische gemäss Anspruch 3, enthaltend
10 bis 50 Gewichts-% einer Verbindung der Formeln I oder II als Komponente (a),
50 bis 90 Gewichts-% der Komponente (b), wobei die Menge der Komponenten (a) und (b) zusammen 100 Gewichts-% beträgt, und
0,1 bis 10 Gewichts-%, bezogen auf die Menge (a) und (b), der Komponente (c).

10. Verfahren zur Herstellung von dreidimensionalen Gegenständen aus den flüssigen, erfindungsgemässen Gemischen gemäss Anspruch 3 mittels eines lithographischen Verfahrens, wobei die Oberfläche einer Schicht aus dem erfindungsgemässen, flüssigen Gemisch ganzflächig oder in einem vorbestimmten Muster mit aktinischem Licht aus einer UV/VIS-Lichtquelle bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

11. Verfahren gemäss Anspruch 10, indem als Strahlenquelle ein Laserstrahl, vorzugsweise ein computergesteuerter Laserstrahl, verwendet wird.

12. Die aus den Gemischen gemäss Anspruch 3 durch Bestrahlen mit aktinischem Licht erhaltenen dreidimensionalen Gegenstände, die aus mehreren aneinander haftenden, verfestigten Schichten aufgebaut sind.

## Claims

1. Use of a tetraacrylate of formula I or II 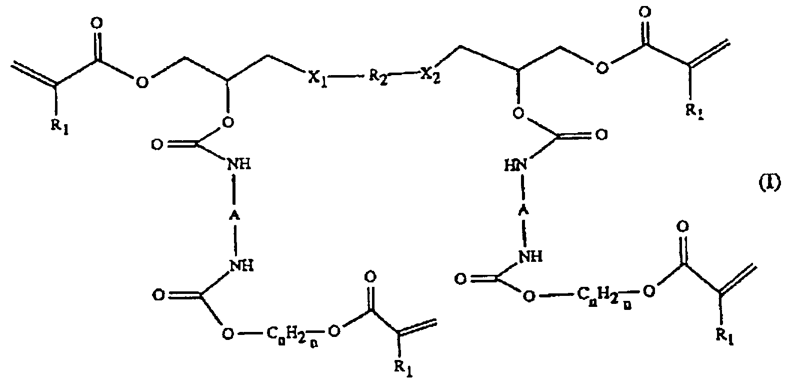 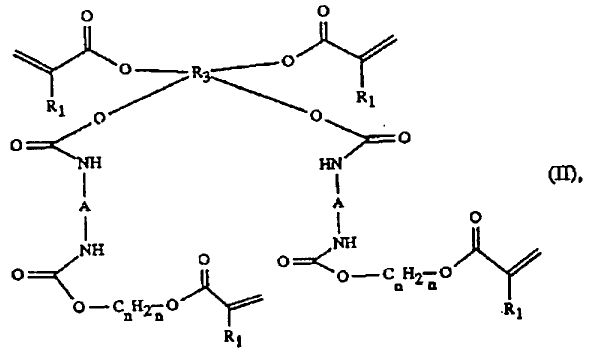 wherein
R₁ is a hydrogen atom or methyl,
X₁ and X₂ are each independently of the other -O- or -CO-O-,
R₂ is a divalent aliphatic, cycloaliphatic or aromatic radical of a diglycidyl compound that no longer contains any glycidyl ether or glycidyl ester groups,
A is a divalent aliphatic, cycloaliphatic or aromatic radical of a diisocyanate compound that no longer contains any isocyanate groups, n is an integer from 1 to 8, and
R₃ is a tetravalent cycloaliphatic radical of a diepoxide compound that contains no 1,2-epoxide group still attached at the cycloaliphatic ring, as formulation component for photopolymerisable resin mixtures that are used in stereolithographic techniques.

2. Use according to claim 1, wherein in formulae I and II
R₁ is a hydrogen atom or methyl,
X₁ and X₂ are each -O- or -CO-O-,
R₂ is a divalent linear or branched hydrocarbon radical of up to 20 carbon atoms, a radical of formula -(alkylene-O)ₘ-alkylene-, in which alkylene contains 1 to 8 carbon atoms and m is zero or an integer from 1 to 100, or else 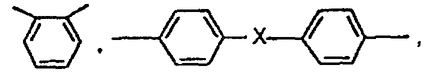 in which X is linear or branched alkylene of 1 to 6 carbon atoms, 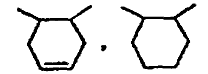 or 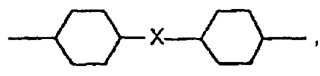 in which X is as defined above,
A is a divalent aliphatic hydrocarbon radical of up to 6 carbon atoms, an unsubstituted or methyl-substituted phenylene radical, a radical of formula 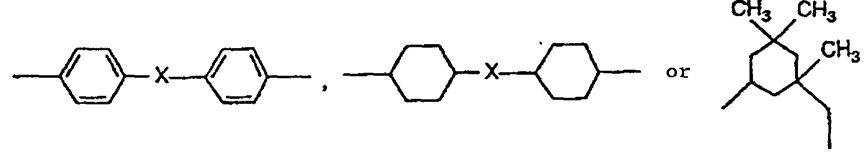 in which X is as defined above, and R₃ is a radical of formula 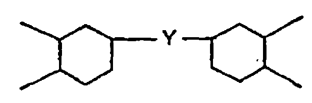 or 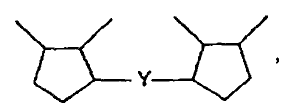 in which Y is -CO-O-CH₂-, -CO-O-(CH₂)_{P}-O-CO- or -CH₂-O-CO-(CH₂)ₚ-CO-O-CH₂-, and p is an integer from 2 to 12.

3. A photopolymerisable mixture comprising
(a) a tetraacrylate of formula I or II 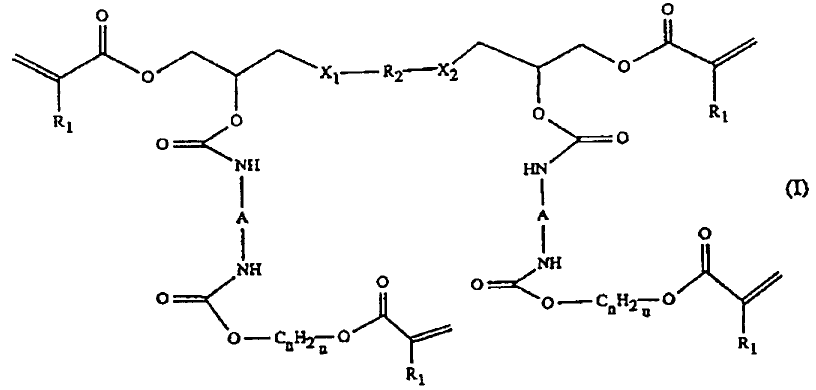 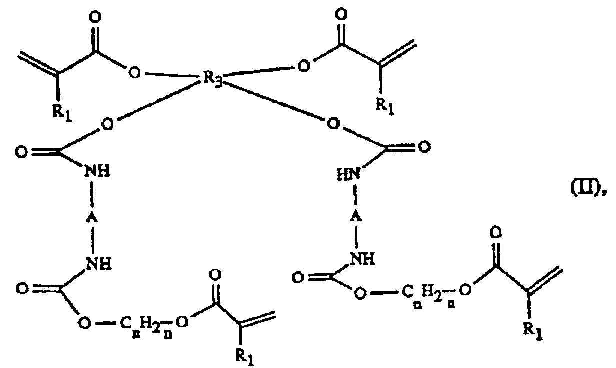 wherein
R₁ is a hydrogen atom or methyl,
X₁ and X₂ are each independently of the other -O- or -CO-O-,
R₂ is a divalent aliphatic, cycloaliphatic or aromatic radical of a diglycidyl compound that no longer contains any glycidyl ether or glycidyl ester groups,
A is a divalent aliphatic, cycloaliphatic or aromatic radical of a diisocyanate compound that no longer contains any isocyanate groups,
n is an integer from 1 to 8, and
R₃ is a tetravalent cycloaliphatic radical of a diepoxide compound that contains no 1,2-epoxide group still attached at the cycloaliphatic ring,
(b) at least one liquid, radically polymerisable compound that differs from component (a), and
(c) a radical photoinitiator.

4. A mixture according to claim 3, comprising as component (a) a tetraacrylate of formula I or II, wherein
R₁ is a hydrogen atom or methyl,
X₁ and X₂ are each -O- or -CO-CO-,
R₂ is a divalent linear or branched hydrocarbon radical of up to 20 carbon atoms, a radical of formula -(alkylene-O)ₘ-alkylene-, in which alkylene contains 1 to 8 carbon atoms and m is zero or an integer from 1 to 100, or else 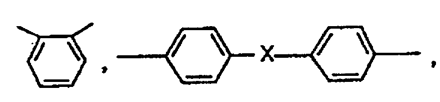 in which
X is linear or branched alkylene of 1 to 6 carbon atoms, 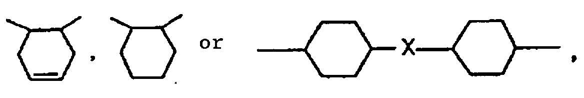 in which X is as defined above,
A is a divalent aliphatic hydrocarbon radical of up to 6 carbon atoms, an unsubstituted or a methyl-substituted phenylene radical, a radical of formula 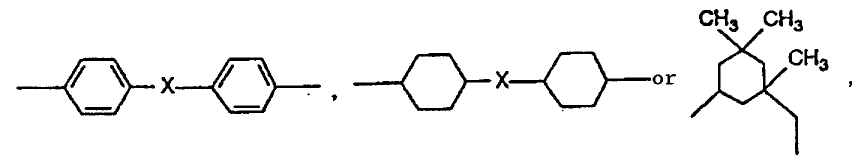 in which X is as defined above, and R₃ is a radical of formula 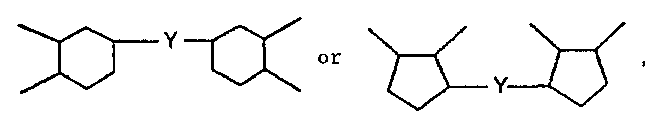 in which Y is -CO-O-CH₂-, -CO-O-(CH₂)ₚ-O-CO- or -CH₂-O-CO-(CH₂)ₚ-CO-O-CH₂-, and p is an integer from 2 to 12.

5. A mixture according to claim 3, comprising as component (b) at least one liquid (meth)acrylate that differs from component (a) and has an acrylate functionality of 1 to 9.

6. A mixture according to claim 3, comprising as component (b) a liquid mixture of aromatic, aliphatic or cycloaliphatic (meth)acrylates with an acrylate functionality of 1 to 9.

7. A mixture according to claim 3, comprising as component (b) a liquid mixture of at least one polyalkylene glycol (meth)acrylate and at least one aromatic, aliphatic or cycloaliphatic (meth)acrylate with an acrylate functionality of 1 to 9.

8. A mixture according to claim 3, comprising
5 to 75 % by weight of a compound of formula I or II as component (a),
25 to 95 % by weight of component (b), the amount of components (a) and (b) together being 100 % by weight, and
0.1 to 10 % by weight, based on the amount of (a) and (b), of component (c).

9. A mixture according to claim 3, comprising
10 to 50 % by weight of a compound of formula I or II as component (a),
50 to 90 % by weight of component (b), the amount of components (a) and (b) together being 100 % by weight, and
0.1 to 10 % by weight, based on the amount of (a) and (b), of component (c).

10. A process for the production of three-dimensional objects from a novel liquid mixture according to claim 3 by a lithographic technique, which involves irradiating a layer of novel liquid mixture over the entire surface or in a predetermined pattern with actinic light from a UV/VIS source, such that within the irradiated areas a layer solidifies in a desired layer thickness, then a new layer of novel mixture is formed on the solidified layer, which layer is likewise irradiated over the entire surface or in a predetermined pattern, and where three-dimensional objects are obtained, comprising a plurality of solidified layers which adhere to one another, by repeated coating and irradiation.

11. A process according to claim 10, which comprises using a laser beam, preferably a computer-controlled laser beam, as radiation source.

12. A three-dimensional object which is obtained by irradiating a mixture according to claim 3 with actinic light and which is formed from a plurality of solidified layers which adhere to one another.

## Revendications

1. Utilisation de tétracrylates de formule I ou II 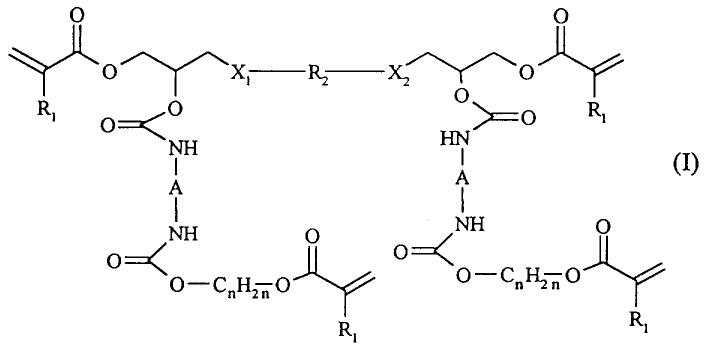 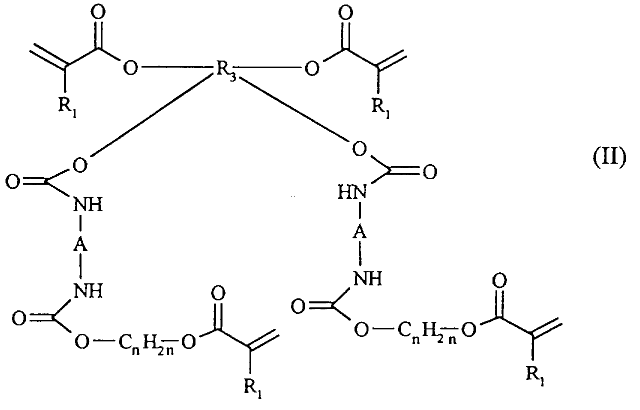 dans lesquelles
R₁ représente un atome d'hydrogène ou un groupe méthyle,
X₁ et X₂ représentent indépendamment l'un de l'autre -O- ou -CO-O-,
R₂ représente un reste divalent aliphatique, cycloaliphatique ou aromatique d'un composé de diglycidyle ne présentant plus de groupe éther ou ester de glycidyle,
A représente un reste divalent aliphatique, cycloaliphatique ou aromatique d'un composé de diisocyanate ne présentant plus de groupe isocyanate,
n est un nombre entier de 1 à 8 et
R₃ représente un reste cycloaliphatique tétravalent d'un composé diépoxy ne présentant plus de groupe 1,2-époxy lié au noyau cycloaliphatique, comme constituants de formulation pour des mélanges dc résincs photopolymérisables qui sont utilisés dans la technique stéréolithographique.

2. Utilisation selon la revendication 1, dans laquelle, dans les formules I et II,
R₁ représente un atome d'hydrogène ou un groupe méthyle,
X₁ et X₂ sont chacun -O- ou -CO-O-,
R₂ représente un reste hydrocarboné divalent linéaire ou ramifié, ayant jusqu'à 20 atomes de carbone, un reste de formule -(alkylène-O)ₘ-alkylène, dans laquelle l'alkylène contient de 1 à 8 atomes de carbone et m est 0 ou un nombre entier de 1 à 100, ou encore 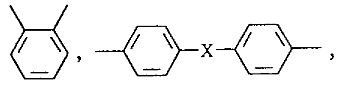 où X représente un alkylène linéaire ou ramifié de 1 à 6 atomes de carbone, 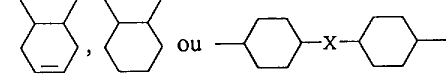 où X a la définition indiquée précédemment,
A représente un reste hydrocarboné divalent aliphatique ayant jusqu'à 6 atomes de carbone, un reste phénylène non substitué ou substitué par méthyle, un reste de formule 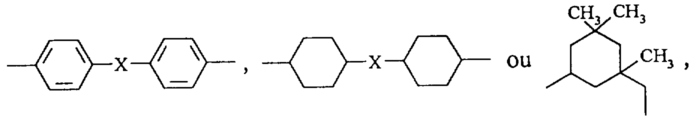 X ayant la définition indiquée précédemment, et
R₃ représente un reste de formule 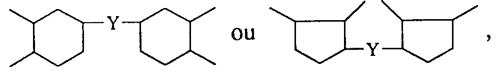 où Y représente un groupe -CO-O-CH₂-, -CO-O-(CH₂)ₚ-O-CO- ou -CH₂-O-CO-(CH₂)ₚ-CO-O-CH₂, et p est un nombre entier de 2 à 12.

3. Mélanges photopolymérisables contenant
a) un tétracrylate de formule I ou II 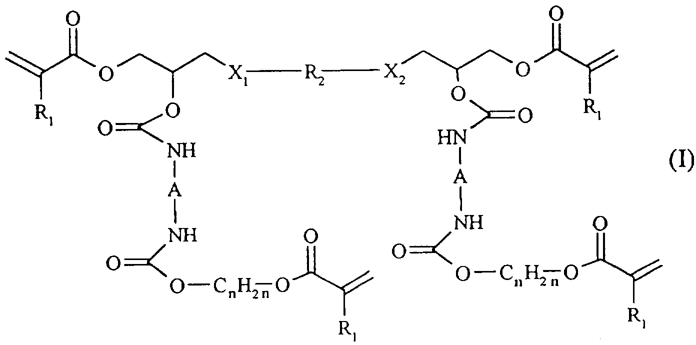 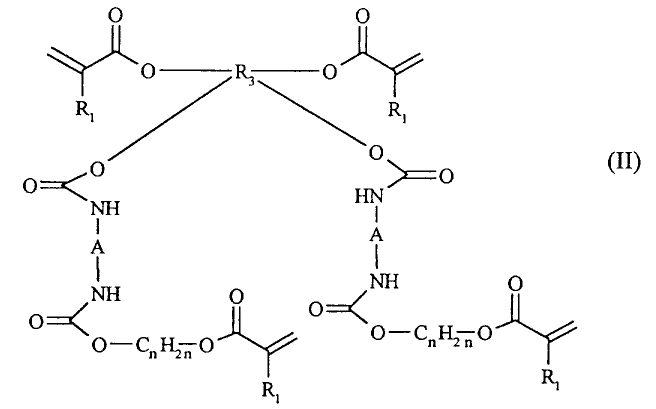 dans lesquelles
R₁ représente un atome d'hydrogène ou un groupe méthyle,
X₁ et X₂ représentent indépendamment l'un de l'autre -O- ou -CO-O-,
R₂ représente un reste divalent aliphatique, cycloaliphatique ou aromatique d'un composé de diglycidyle ne présentant plus de groupe éther ou ester de glycidyle,
A représente un reste divalent aliphatique, cycloaliphatique ou aromatique d'un composé de diisocyanate ne présentant plus de groupe isocyanate,
n est un nombre entier de 1 à 8 et
R₃ représente un reste cycloaliphatique tétravalent d'un composé diépoxy ne présentant plus de groupe 1,2-époxy lié au noyau cycloaliphatique,
(b) au moins un composé liquide polymérisable par voie radicalaire différent du constituant (a), et
(c) un photoamorceur radicalaire.

4. Mélanges selon la revendication 3, contenant comme constituant (a) un tétracrylate de formule I ou II dans lesquelles
R₁ représente un atome d'hydrogène ou un groupe méthyle,
X₁ et X₂ sont chacun -O- ou -CO-O-,
R₂ représente un reste hydrocarboné divalent linéaire ou ramifié, ayant jusqu'à 20 atomes de carbone, un reste de formule -(alkylène-O)ₘ-alkylène, dans laquelle l'alkylène contient de 1 à 8 atomes de carbone et m est 0 ou un nombre entier de 1 à 100, ou encore 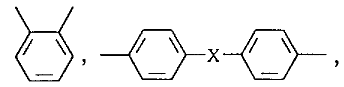 où X représente un alkylène linéaire ou ramifié de 1 à 6 atomes de carbone, 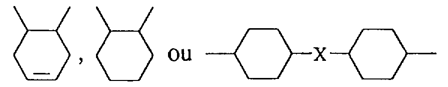 où X a la définition indiquée précédemment,
A représente un reste hydrocarboné divalent aliphatique ayant jusqu'à 6 atomes de carbone, un reste phénylène non substitué ou substitué par méthyle, un reste de formule 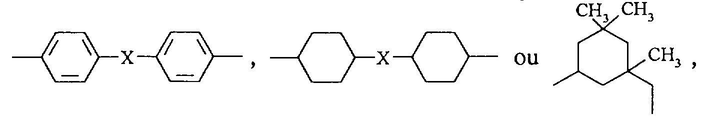 X ayant la définition indiquée précédemment, et
R₃ représente un reste de formule 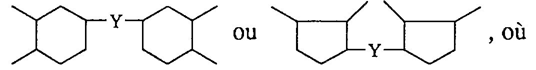 Y représente un groupe -CO-O-CH₂-, -CO-O-(CH₂)ₚ-O-CO- ou -CH₂-O-CO-(CH₂)ₚ-CO-O-CH₂, et p est un nombre entier de 2 à 12.

5. Mélanges selon la revendication 3, contenant comme constituant (b) au moins un (méth)acrylate liquide différent du constituant (a) et ayant 1 à 9 fonctions acrylate.

6. Mélanges selon la revendication 3, contenant comme constituant (b) un mélange liquide de (méth)acrylates aromatiques, aliphatiques ou cycloaliphatiques ayant 1 à 9 fonctions acrylate.

7. Mélanges selon la revendication 3, contenant comme constituant (b) un mélange liquide d'au moins un (méth)acrylate de polyalkylèneglycol et d'au moins un (méth)acrylate aromatique, aliphatique ou cycloaliphatique ayant 1 à 9 fonctions acrylate.

8. Mélanges selon la revendication 3, contenant
5 à 75 % en masse d'un composé de formule I ou II comme constituant (a),
25 à 95 % en masse du constituant (b), la quantité des constituants (a) et (b) s'élevant en tout à 100 % en masse, et
0,1 à 10 % en masse, par rapport à la quantité de (a) et (b), de constituant (c).

9. Mélanges selon la revendication 3, contenant
10 à 50 % en masse d'un composé de formule I ou II comme constituant (a),
50 à 90 % en masse du constituant (b), la quantité des constituants (a) et (b) s'élevant en tout à 100 % en masse, et
0,1 à 10 % en masse, par rapport à la quantité de (a) et (b), de constituant (c).

10. Procédé de production d'objets en trois dimensions à partir des mélanges liquides de l'invention selon la revendication 3 par une technique stéréolithographique, dans lequel on expose la surface d'une couche du mélange liquide selon l'invention, sur toute la surface ou selon une configuration prédéterminée, à la lumière actinique d'une source de lumière UV/visible de façon que, dans les zones exposées, la couche durcisse en une épaisseur de couche désirée, puis on forme une nouvelle couche de mélange selon l'invention sur la couche durcie, on l'expose également sur toute la surface ou selon une configuration prédéterminée, et on obtient, en répétant l'application de couches et l'exposition, des objets en trois dimensions composés de plusieurs couches durcies adhérant entre elles.

11. Procédé selon la revendication 10, dans lequel on utilise comme source de rayonnement un rayon laser, de préférence un rayon laser commandé par ordinateur.

12. Objets en trois dimensions obtenus à partir des mélanges selon la revendication 3 par exposition à une lumière actinique, qui sont constitués de plusieurs couches durcies adhérant entre elles.
